(19) Europäisches Patentamt
European Patent Office
Office européen des brevets

(11) **EP 4 618 700 A1**

(12) **EUROPEAN PATENT APPLICATION**
published in accordance with Art. 153(4) EPC

(43) Date of publication:
**17.09.2025 Bulletin 2025/38**

(21) Application number: **23888663.4**

(22) Date of filing: **06.11.2023**

(51) International Patent Classification (IPC):
*H05K 3/28* (2006.01)       *H01L 23/12* (2006.01)
*H05K 1/05* (2006.01)

(52) Cooperative Patent Classification (CPC):
**H01L 23/12; H05K 1/05; H05K 3/28**

(86) International application number:
**PCT/JP2023/039917**

(87) International publication number:
**WO 2024/101316 (16.05.2024 Gazette 2024/20)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(30) Priority: **08.11.2022 JP 2022179127**

(71) Applicant: **NHK Spring Co., Ltd.
Kanagawa 236-0004 (JP)**

(72) Inventors:
• YUKIMASA, Taro
  Yokohama-shi, Kanagawa 236-0004 (JP)
• NATSUME, Yutaka
  Yokohama-shi, Kanagawa 236-0004 (JP)
• SUZUKI, Kohei
  Yokohama-shi, Kanagawa 236-0004 (JP)

(74) Representative: **DREISS Patentanwälte PartG
mbB
Friedrichstraße 6
70174 Stuttgart (DE)**

(54) **EMBEDDING RESIN, CIRCUIT BOARD, ELECTRONIC MODULE, AND METHOD FOR MANUFACTURING CIRCUIT BOARD**

(57)     In a structure in which a resin fills in gaps between wiring patterns, the resin is adjusted in advance so as to reduce the influence of stress in the filling resin. The resin that is to fill in gaps between wiring patterns of a circuit board is an embedding resin with a coefficient of linear expansion and a Young's modulus such that, in a stack in which a base substrate, an insulating layer and a resin portion formed of the embedding resin are stacked in this order, stress at an interface of the insulating layer that is in contact with the resin portion is at most 13.0 MPa. This stress is calculated by the formula $\sigma=(P/bh)+(Ey/R)$, which is based on a 4-layer model using a temperature difference between room temperature and a glass transition temperature of the insulating resin. $\sigma$ represents stress (MPa), $P$ represents axial force (N), $b$ represents a depth measurement of the insulating layer (mm), $h$ represents a thickness of the insulating layer (mm), $E$ represents the Young's modulus (MPa), $y$ represents distance from a neutral plane (mm), and $R$ represents a radius of curvature (mm).

FIG.2

**Description**

Technical Field

The present disclosure relates to an embedding resin, a circuit board using the embedding resin, an electronic module equipped with the circuit board, and a method for manufacturing the circuit board.

Background Art

Japanese Patent Application Laid-Open (JP-A) No. 2021-34534 discloses a circuit board in which a circuit portion and a base substrate are stacked with an insulating layer therebetween. Wiring patterns are formed by etching of a metal plate structuring the circuit portion, and a resin that is different from the insulating layer is filled into gaps between the wiring patterns. Electronic components such as, for example, semiconductor devices and the like may be mounted at the circuit board, and the electronic components and circuit board may be sealed in by a sealing resin.

SUMMARY OF INVENTION

Technical Problem

As usage environments for electronic devices have become more diverse in recent years, there have been calls for increases in current capacity of circuit boards. The current capacity of a circuit board may be increased by making a metal plate constituting wiring patterns thicker. However, when a metal plate constituting wiring patterns is made thicker, gaps between the wiring patterns may not be thoroughly filled in with sealing resin in a resin sealing process. Thus, the insulating layer may separate from the sealing resin, including a surface at the side of the insulating layer at which the wiring patterns are disposed, and bubbles may be formed. When a voltage is applied to the circuit board in this state, a partial discharge occurs between a wiring pattern portion that is not covered by the sealing resin and the insulating layer. These partial discharges are a cause of dielectric breakdown.

In the above-mentioned JP-A No. 2021-34534, because a resin is filled into the gaps between the wiring patterns, the separation from the sealing resin and formation of bubbles mentioned above may be prevented. However, when this resin filling in the gaps between the wiring patterns expands due to heating in a subsequent reflow process or the like, stress occurs inside the resin. The neighboring insulating layer may be damaged by this stress, and cracks may form in the insulating layer. These cracks may be a cause of dielectric breakdown when a voltage is applied.

The present disclosure provides an embedding resin that is adjusted in advance such that, in a structure in which the resin fills in gaps between wiring patterns, the influence of stress occurring in the filling resin is reduced, and provides a circuit board that is filled in with this embedding resin.

Solution to Problem

A first aspect of the present disclosure is an embedding resin that is a resin to fill in a gap between wiring patterns of a circuit board. The embedding resin features a coefficient of linear expansion and a Young's modulus such that, in a stack in which a base substrate, an insulating layer and a resin portion that is formed of the embedding resin are stacked in this order, stress at an interface of the insulating layer that is in contact with the resin portion is at most 13.0 MPa, the stress being calculated by the following formula (C1) based on a 4-layer model using a temperature difference between room temperature and a glass transition temperature of the insulating resin.

[Formula 1]

$$\sigma = \frac{P}{bh} + \frac{Ey}{R} \tag{C1}$$

[Note that, in formula (C1),

  $\sigma$ represents stress (MPa),
  $P$ represents axial force (N),
  $b$ represents a depth measurement of the insulating layer (mm),
  $h$ represents a thickness of the insulating layer (mm),
  $E$ represents the Young's modulus (MPa),
  $y$ represents distance from a neutral plane (mm),

and R represents a radius of curvature (mm).]

According to the embedding resin of the first aspect, an embedding resin may be provided with which the influence of stress occurring inside the embedding resin due to heating is suppressed. Therefore, damage that the insulating layer neighboring the embedding resin is subjected to, and the formation of cracks in the insulating layer, may be prevented. The meaning of the term "embedding resin" as used in the present specification is intended to include a resin that is used for the purpose of, in a stack body in which a conductor layer structuring wiring patterns and a base substrate are stacked with an insulating layer therebetween, filling in gaps between the wiring patterns before electronic components are mounted.

In an embedding resin according to a second aspect, in the first aspect, the embedding resin includes a filler.

According to the embedding resin of the second aspect, a coefficient of linear expansion and Young's modulus of the embedding resin may be regulated by a filler content amount.

In an embedding resin according to a third aspect, in the first aspect or the second aspect, the embedding resin includes an epoxy resin.

According to the embedding resin of the third aspect, because the epoxy resin is employed, the embedding resin may withstand a reflow temperature when electronic components are being mounted.

A fourth aspect of the present disclosure is a circuit board including: a base substrate; an insulating layer stacked on the base substrate; a conductor layer stacked on the insulating layer at an opposite side from a side at which the base substrate is disposed, the conductor layer structuring wiring patterns; and a resin portion formed from the embedding resin according to any one of the first to third aspects the resin portion filling in a gap between the wiring patterns.

According to the circuit board of the fourth aspect, because the embedding resin in which the influence of stress caused by heating is suppressed fills in gaps between wiring patterns, the formation of cracks in the neighboring insulating layer due to stress caused by heating in a subsequent reflow process or the like may be prevented.

A fifth aspect of the present disclosure is an electronic module including: the circuit board according to the fourth aspect; an electronic component mounted at the circuit board; and a sealing resin that seals in the circuit board and the electronic component.

According to the electronic module of the fifth aspect, electronic components are mounted at the circuit board, and the circuit board and electronic components are sealed in by the sealing resin. Because this circuit board is filled in with the embedding resin in which the influence of stress caused by heating is suppressed, cracks may not form in the insulating layer, and dielectric breakdown resulting from cracks when a voltage is applied may be avoided.

A sixth aspect of the present disclosure is a method for manufacturing a circuit board, including: a preparing step of preparing a stack body in which a conductor layer structuring wiring patterns and a base substrate are stacked with an insulating layer therebetween; and a resin filling step of filling in a gap between the wiring patterns with a raw material of the embedding resin according to any one of the first to third aspects.

According to the method for manufacturing a circuit board of the sixth aspect, the embedding resin in which the influence of stress caused by heating is suppressed fills in gaps between wiring patterns. Therefore, a method for manufacturing a circuit board may be provided that may prevent cracks forming in the neighboring insulating layer due to stress caused by heating in a subsequent reflow process or the like.

Advantageous Effects of Invention

According to the present disclosure as described above, an embedding resin may be provided that is adjusted in advance such that the influence of stress occurring in the resin filling in gaps between wiring patterns is reduced. When the embedding resin according to the present disclosure is used, because the embedding resin is adjusted so as to reduce the influence of stress on a circuit board filled in with the embedding resin, damage to a neighboring insulating layer may be suppressed. Moreover, an electronic module using this circuit board may avoid dielectric breakdown resulting from damage to the insulating layer when a voltage is applied.

BRIEF DESCRIPTION OF DRAWINGS

Fig. 1 is a perspective view depicting a circuit board that is filled in with an embedding resin according to an exemplary embodiment.

Fig. 2 is a sectional diagram showing a section cut along line F2-F2 in Fig. 1.

Fig. 3 is a diagram showing a 4-layer model.

Fig. 4 is a diagram showing the 4-layer model after thermal deformation.

Fig. 5 is a diagram showing a beam after thermal deformation.

Fig. 6 is a chart showing manufacturing steps of a method for manufacturing a circuit board according to the exemplary embodiment.

Fig. 7 is a diagram showing a 4-layer beam stack structure in correspondence with stress inclinations at respective layers of Comparative Example 1.

DESCRIPTION OF EMBODIMENTS

A first aspect of the present disclosure is an embedding resin that is a resin to fill in a gap between wiring patterns of a circuit board. The embedding resin has a coefficient of linear expansion and a Young's modulus such that, in a stack in which a base substrate, an insulating layer and a resin portion that is formed of the embedding resin are stacked in this order, stress at an interface of the insulating layer that is in contact with the resin portion is at most 13.0 MPa, the stress being calculated by the following formula (C1) based on a 4-layer model using a temperature difference between room temperature and a glass transition temperature of the insulating resin.

[Formular 2]

$$\sigma = \frac{P}{bh} + \frac{Ey}{R} \tag{C1}$$

[Note that, in formula (C1), $\sigma$ represents stress (MPa), P represents axial force (N), b represents a depth measurement of the insulating layer (mm), h represents a thickness of the insulating layer (mm), E represents the Young's modulus (MPa), y represents distance from a neutral plane (mm), and R represents a radius of curvature (mm).]

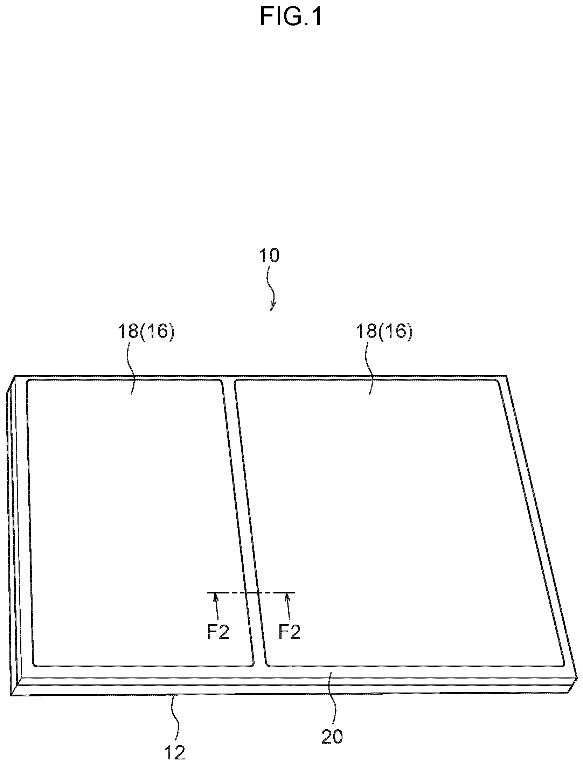

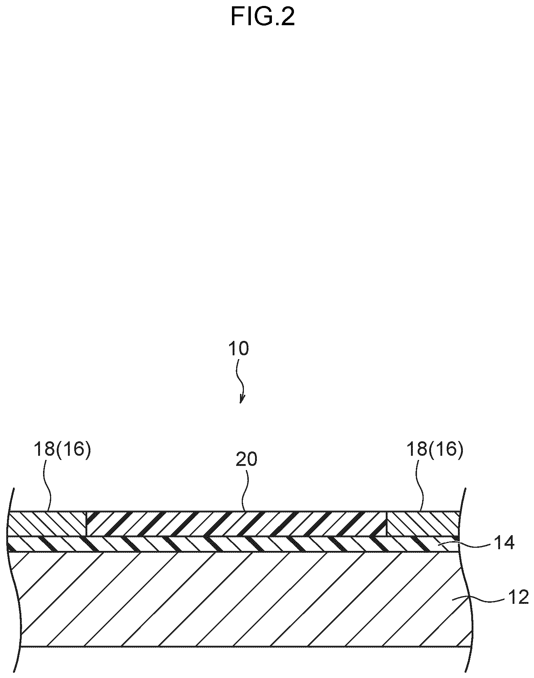

Firstly, an example of a circuit board relating to an exemplary embodiment of the present disclosure that is filled in with the embedding resin according to the first aspect is described with reference to Fig. 1 and Fig. 2. Details of the embedding resin according to the first aspect will become clear through this description. Fig. 1 shows a circuit board 10 in a perspective view. Electronic components (for example, semiconductor devices), which are heat-generating components, are mounted on the circuit board 10. As shown in Fig. 1 and Fig. 2, the circuit board 10 includes a metal base 12, an insulating layer 14 stacked on the metal base 12, a metal layer 16 that is stacked at the opposite side of the insulating layer 14 from the side thereof at which the metal base 12 is disposed and that structures wiring patterns (circuit patterns) 18, and a resin portion 20 that fills in gaps between the wiring patterns 18. The embedding resin according to the exemplary embodiment of the present disclosure is filled in at the resin portion 20. The metal base 12 is equivalent to "a base substrate" of the present disclosure, and the metal layer 16 is equivalent to "a conductor layer" of the present disclosure.

The metal base 12 is a circuit board constituted by a metal material. A metal plate material that is used to constitute the metal base 12 is a material with high thermal conductivity such as, for example, copper, a copper alloy, aluminium, an aluminium alloy or the like. A thickness of the metal base 12 is set, for example, in a range from 1 mm to 3 mm. Heat dissipating means (not shown in the drawings) such as a heat dissipating fan, a radiator or the like may be mounted at a face of the metal base 12 at the opposite side thereof from the side at which the insulating layer 14 is disposed.

The insulating layer 14 is, for example, an electrically insulative synthetic resin into which an electrically insulative and thermally conductive filler is mixed. This synthetic resin may be, for example, an epoxy resin that is a thermosetting type of synthetic resin with an epoxy base. Alternative examples include cyanate resins, silicone resins and amide resins. The resin may be a single resin and may be two or more resins. The above-mentioned filler may be, for example, silicon dioxide (silica) aluminium oxide (alumina), alumina nitride or boron nitride. Fillers that can be used include fillers that are chemically stable and have high thermal conductivity and electrical insulativity. The filler may be a single filler and may be two or more fillers. A thickness of the insulating layer 14 is set in, for example, a range from 0.06 mm to 0.2 mm. Instead of a filler with thermal conductivity, the insulating layer 14 may include glass fibers mixed into an electrically insulative synthetic resin.

The metal layer 16 is constituted of, for example, an electrically conductive metal material. The metal material that is used to constitute the metal layer 16 is, for example, rolled copper plate, aluminium plate or the like. The thickness of the metal layer 16 is set, for example, in a range from 0.3 mm to 1.5 mm. The metal layer 16 is processed by etching of the metal layer stacked at the opposite side of the insulating layer 14 from the side at which the metal base 12 is disposed, thus forming the predetermined wiring patterns 18. Metal plating (not shown in the drawings) is applied to the surfaces of the wiring patterns 18 without the surfaces being polished. The metal layer 16 may, for example, be punched out by die-pressing of a lead frame. However, burrs and the like are likely to occur at a time of die-pressing. Accordingly, processing to remove these burrs is required before the metal layer 16 is stacked on the insulating layer 14.

The embedding resin forming the resin portion 20 is, for example, a thermosetting resin such as an epoxy resin or the like. An electrically insulative and thermally conductive filler may be mixed in. The filler that is used is, for example, silicon dioxide (silica), aluminium oxide (alumina) or the like. A thickness of the resin portion 20 is set, for example, in a range from 0.2 mm to 0.5 mm. Gaps between the wiring patterns 18 are filled in by the resin portion 20. An epoxy resin or the like may be employed as the resin used for the embedded resin. The filler that is mixed into the embedded resin may be silicon dioxide, aluminium oxide or the like. The filler may be a single filler and may be two or more fillers.

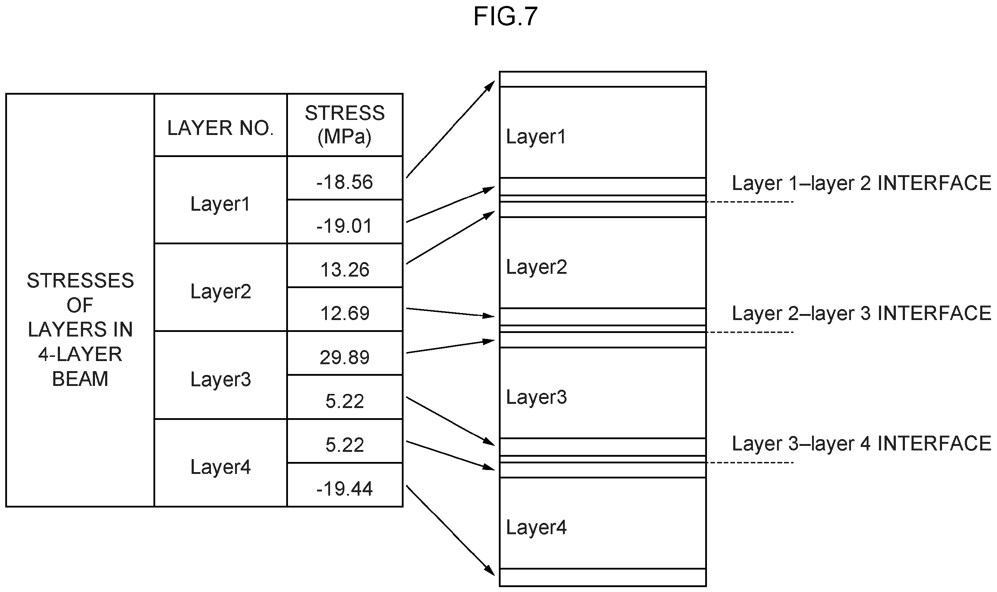

The embedding resin is adjusted so as to reduce the influence of stress occurring inside the embedding resin due to heating. More specifically, as illustrated in Fig. 2, the embedding resin filled into a gap between the wiring patterns 18 serves as the resin portion 20 and forms a stack with the insulating layer 14 and the metal base 12, structuring a three-layer stack body. Physical quantities (a coefficient of linear expansion and Young's modulus) of the embedding resin are adjusted in advance such that stresses at interfaces of the insulating layer 14 in contact with the resin portion 20 of the stack body (see Fig. 7) are not more than a predetermined value.

A stress at an interface of the insulating layer 14 in contact with the resin portion 20 may be found by a calculation formula using multilayered beam theory (microscopic deflection). J. Oda and S. Abe, "Analysis of Stress and Deflection of Printed Plate Board Using Multilayered Beam Theory", Transactions of the Japan Society of Mechanical Engineers. A, 1993, vol. 59, issue 563, pp. 1777-1782, article no. 92-1435 may be referred to in regard to multilayered beam theory. As a theoretical model of a printed circuit board, multilayered beam theory considers a multilayer beam with n layers that is subjected to a temperature change, and uses a cantilevered multilayer beam with n layers, taking account of left-and-right symmetry of deformations, as the theoretical model.

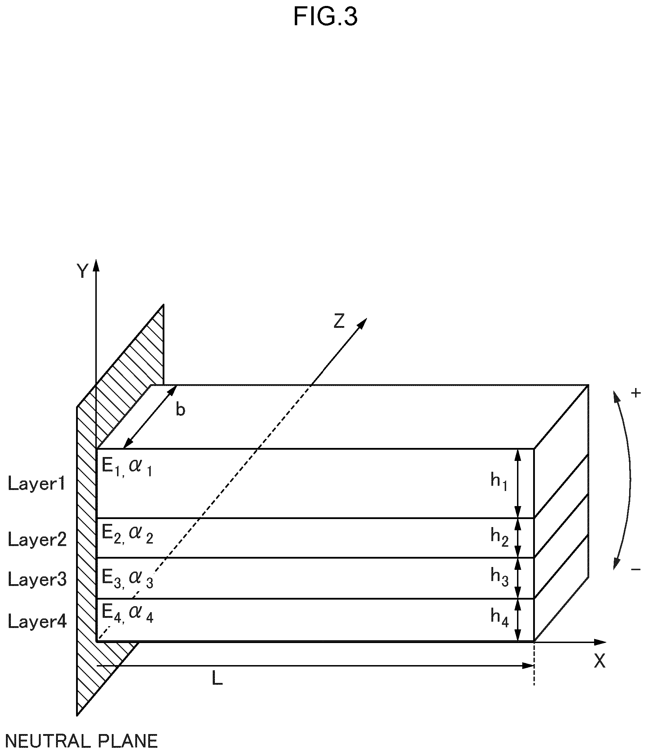

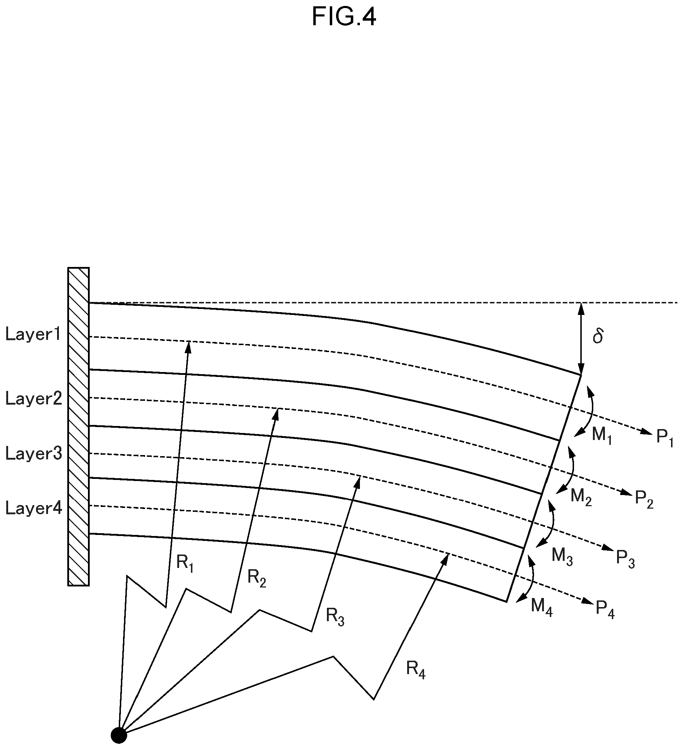

A specific method of the present Application for using multilayered beam theory to calculate stress follows. Given a structure with left-and-right symmetry, assume a 4-layer beam model (n=4) as illustrated in Fig. 3. In the 3-layer stack body of the present application (the resin portion 20, the insulating layer 14 and the metal base 12), the thickness of the metal base 12 is divided into halves and calculations are performed for a 4-layer stack body structured by the resin portion 20, the insulating layer 14, (half the thickness of) the metal base 12, and (half the thickness of) the metal base 12. A situation in which the 4-layer cantilever beam shown in Fig. 3 deforms as illustrated in Fig. 4 is considered. When a temperature difference $\Delta T$ is applied to the 4-layer beam of Fig. 3, a thermal deformation as in Fig. 4 occurs. Deflections of the layers ($\varepsilon_i$, i = 1 to 4) are calculated as sums (formula (4)) of deflections due to thermal expansion from formula (1), deflections due to axial force from formula (2), and deflections due to torsional moment from formula (3).

[Formula 3]

$$\varepsilon_i' = \alpha_i \Delta T \tag{1}$$

$$\varepsilon_i'' = P_i \, / \, (bh_i E_i) \tag{2}$$

$$\varepsilon_i''' = M_i y \, / \, (I_i E_i) = y/R_i \tag{3}$$

$$\varepsilon_i = \varepsilon_i' + \varepsilon_i'' + \varepsilon_i''' = \alpha_i \Delta T + P_i/(bh_i E_i) + y/R_i \tag{4}$$

$\alpha_i$: coefficient of linear expansion of layer i
$P_i$: axial force of layer i
$E_i$: Young's modulus of layer i
$M_i$: torsional moment of layer i
$I_i$: geometrical moment of inertia of layer i
$R_i$: radius of curvature of layer i at neutral plane
$h_i$: layer thickness of layer i
y: distance from neutral plane
b: depth measurement of the 4-layer beam

A requirement for continuity of deflection at joining interfaces of the layers gives formula (5) (in which i = 1 to n-1).
[Formula 4]

$$\alpha_i \Delta T + P_i/(bh_i E_i) - h_i/(2R_i)$$
$$= \alpha_{i+1} \Delta T + P_{i+1}/(bh_{i+1} E_{i+1}) + h_{i+1}/(2R_{i+1}) \tag{5}$$

A requirement for equilibrium of axial forces gives formula (6).
[Formula 5]

$$\sum_{i=1}^{n} P_i = 0 \tag{6}$$

A requirement for equilibrium of torsional moments gives formula (7).

[Formula 6]

$$\sum_{i=1}^{n} M_i + P_1(\bar{y} - h_1/2) + P_2(\bar{y} - h_1 - h_2/2) + \cdots$$
$$+ P_n(\bar{y} - h_1 - h_2 \cdots - h_n/2) = 0 \tag{7}$$

The y bar (the axis at the "y") represents the position of a neutral plane of the 4-layer beam.

Assuming thicknesses of the layers are much smaller than radiuses of curvature gives formula (8).

[Formula 7]

$$R = R_1 = R_2 = R_3 = R_4 \tag{8}$$

P and 1/R are found by using formula (5) to formula (7) as simultaneous equations. However, formula (9) applies.

[Formula 8]

$$\sum_{i=1}^{n} M_i = \sum_{i=1}^{n} (E_i I_i)/R \tag{9}$$

Simultaneous equations for the 4-layer beam give formula (10).

[Formula 9]

$$\begin{vmatrix} \dfrac{1}{bh_1E_1} & \dfrac{-1}{bh_2E_2} & 0 & 0 & \dfrac{-(h_1+h_2)}{2} \\ 0 & \dfrac{1}{bh_2E_2} & \dfrac{-1}{bh_3E_3} & 0 & \dfrac{-(h_2+h_3)}{2} \\ 0 & 0 & \dfrac{1}{bh_3E_3} & \dfrac{-1}{bh_4E_4} & \dfrac{-(h_3+h_4)}{2} \\ \dfrac{h_1}{2} & h_1+\dfrac{h_2}{2} & h_1+h_2+\dfrac{h_3}{2} & h_1+h_2+h_3+\dfrac{h_4}{2} & \sum_{i=1}^{n} E_i I_i \\ 1 & 1 & 1 & 1 & 0 \end{vmatrix} \begin{vmatrix} P_1 \\ P_2 \\ P_3 \\ P_4 \\ 1/R \end{vmatrix} = \begin{vmatrix} (\alpha_2-\alpha_1)\Delta T \\ (\alpha_3-\alpha_2)\Delta T \\ (\alpha_4-\alpha_3)\Delta T \\ 0 \\ 0 \end{vmatrix} \tag{10}$$

If formula (11) is applied, the values of $P_1$ to $P_4$ and 1/R that are to be found may be found from formula (12).

[Formula 10]

$$A = \begin{vmatrix} \dfrac{1}{bh_1E_1} & \dfrac{-1}{bh_2E_2} & 0 & 0 & \dfrac{-(h_1+h_2)}{2} \\ 0 & \dfrac{1}{bh_2E_2} & \dfrac{-1}{bh_3E_3} & 0 & \dfrac{-(h_2+h_3)}{2} \\ 0 & 0 & \dfrac{1}{bh_3E_3} & \dfrac{-1}{bh_4E_4} & \dfrac{-(h_3+h_4)}{2} \\ \dfrac{h_1}{2} & h_1+\dfrac{h_2}{2} & h_1+h_2+\dfrac{h_3}{2} & h_1+h_2+h_3+\dfrac{h_4}{2} & \sum_{i=1}^{n} E_i I_i \\ 1 & 1 & 1 & 1 & 0 \end{vmatrix} \tag{11}$$

[Formula 11]

$$\begin{vmatrix} P_1 \\ P_2 \\ P_3 \\ P_4 \\ 1/R \end{vmatrix} = A^{-1} \begin{vmatrix} (\alpha_2-\alpha_1)\Delta T \\ (\alpha_3-\alpha_2)\Delta T \\ (\alpha_4-\alpha_3)\Delta T \\ 0 \\ 0 \end{vmatrix} \qquad (12)$$

Next, a stress $\sigma_i$ in each layer is obtained by multiplying the deflection of the layer by the respective Young's modulus. Because each deflection $\varepsilon'_i$ caused by thermal expansion does not cause stress, formula (4) can be rewritten as formula (13) below. Therefore, the stress $\sigma i$ occurring in each layer may be calculated by substituting the values $P_i$ and $1/R$ that have been found and the values b, $h_i$, $y_i$ and $E_i$ into formula (13).

[Formula 12]

$$\sigma_i = \frac{P_i}{bh_i} + \frac{E_i y_i}{R} \qquad (13)$$

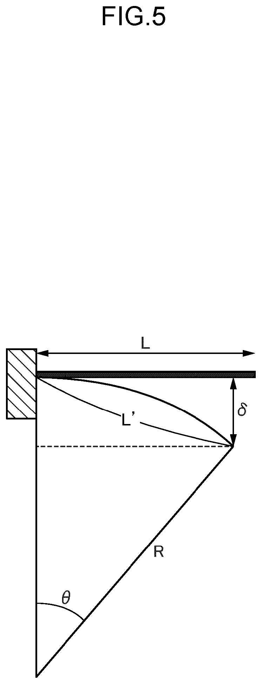

A warp δ of the multilayer beam is the deformation illustrated in Fig. 5, which can be expressed by the following formula (14).

[Formula 13]

$$\delta = R(1 - \cos\theta) \qquad (14)$$

The term cosθ is as in formula (15).

[Formula 14]

$$\cos\theta = 1 - \frac{\theta^2}{2} \quad , \quad \theta = \frac{L'}{R} \qquad (15)$$

Assuming that a warp δ of the 4-layer beam caused by a temperature change is very small and ignoring extension of the beam (L=L'), the warp δ according to formula (14) and formula (15) can be expressed by the following formula (16).

[Formula 15]

$$\delta = \frac{L^2}{2R} \qquad (16)$$

L: length of the 4-layer beam

Using multilayered beam theory, a warp amount of a simple 4-layer beam and stresses occurring between the layers may be calculated from these theoretical formulas by using "STACK BODY SIMPLE THERMAL WARPING CALCULATION TOOL ver. 1.7", manufactured by Wave Technology Inc.

As shown in Fig. 2, the circuit board 10 includes three layers, the resin portion 20, the insulating layer 14 and the metal base 12 (copper). Accordingly, stresses between the layers are calculated using the "STACK BODY SIMPLE THERMAL WARPING CALCULATION TOOL ver. 1.7" on the 4-layer beam model shown in Fig. 3 in which layer 1 is the resin portion 20, layer 2 is the insulating layer 14, and layer 3 and layer 4 are the thickness of the metal base 12 divided into halves. Here, a temperature difference between room temperature (25°C) and the temperature when the circuit board 10 is heated to 300°C (a temperature for mounting of electronic components, which is a reflow temperature) is used as the temperature difference ΔT (the reflow temperature - 25°C). The coefficient of linear expansion and Young's modulus of the embedding resin are adjusted in accordance with types of resin and types and content amounts of filler, stresses at an interface of the insulating layer 14 in contact with the resin portion 20 are found by the calculations, and a resin in which the stress of the insulating layer 14 is at most a predetermined value is used as the embedding resin.

In general, the Young's modulus and coefficient of linear expansion of a resin change greatly with a transition at a glass transition temperature Tg. More specifically, the Young's modulus tends to be large below Tg and small above Tg, and the coefficient of linear expansion tends to be small below Tg and large above Tg. The present inventors have found that the insulating layer 14 tends to softness above Tg and cracks do not form even when tensile stress is acting, but in rigid states below Tg, cracks may form when tensile stress is acting.

In the present disclosure, the stress of the insulating layer that is found using the 4-layer beam model is preferably not more than 13.0 MPa, and is particularly preferably not more than 12.6 MPa. An insulating layer that exhibits stress of 13.0 MPa or less suppresses the influence of stress from the resin portion 20 even when going through thermal hysteresis at a time of mounting (a reflow process). As a result, the formation of cracks in the insulating layer 14 may be prevented. Therefore, when the embedding resin contains a filler, a content amount (volume percentage) of the filler is not particularly limited provided the resin portion 20 can be formed and the stress in the insulating layer 14 that is found using the 4-layer beam model is at most 13.0 MPa.

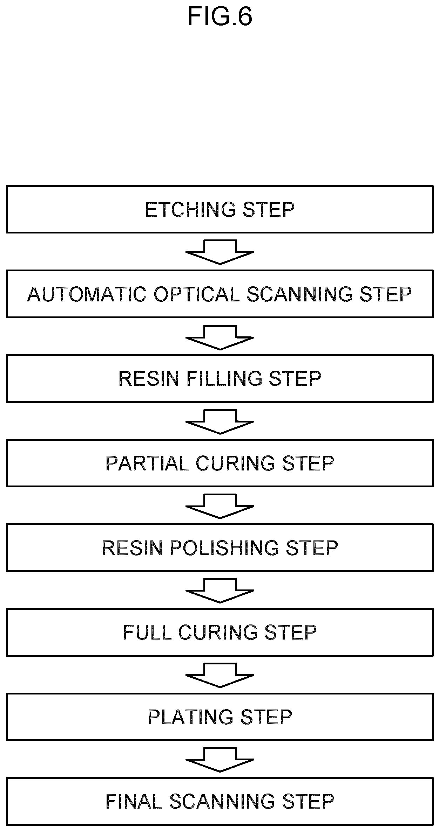

Now, the method for manufacturing a circuit board according to the sixth aspect is described, using the method for manufacturing the circuit board to manufacture the circuit board 10 with the structure described above as an example. Fig. 6 shows manufacturing steps of the method for manufacturing the circuit board according to the present exemplary embodiment in a chart. In the method for manufacturing the circuit board according to the present exemplary embodiment, first a stack body in which the metal base 12, the insulating layer 14 and the metal layer 16 are stacked is prepared, and then the metal layer 16 is etched to form the wiring patterns 18.

A publicly known method may be employed as a method for manufacturing this stack body. A liquid material (varnish material) serving as a raw material of the insulating layer 14 may be applied to at least one of the metal base 12 and the metal layer 16 by, for example, roll coating, bar coating or screen printing. Then, the liquid material on the metal base 12 or metal layer 16 is dried by natural drying or forced drying, thus providing the insulating layer 14. The insulating layer 14 at this time may be in a state that is not completely hardened (a "B stage" state). Next, the metal layer 16 is formed on a surface of the insulating layer 14. More specifically, the metal layer 16 (for example, rolled copper plate) that is to form the wiring patterns 18 is laminated by hot-pressing or the like onto the surface of the insulating layer 14. Thus, the stack body in which the metal layer 16 that is to form the wiring patterns 18 and the metal base 12 are stacked with the insulating layer 14 therebetween is provided.

Then, in an etching step, the metal layer 16 of the stack body obtained as described above is etched to form the predetermined wiring patterns 18. The etched stack body is then scanned for the presence of defects in an automatic optical scanning step. The etching step and automatic optical scanning step are equivalent to "a preparing step" of the present disclosure.

Then, in a resin filling step, the raw material of the embedding resin according to the present disclosure fills in gaps between the wiring patterns 18. A filling method is not particularly limited; a publicly known method may be employed. For example, the filling may be conducted by screen printing.

In a partial curing step after the resin filling step, the raw material of the embedding resin that is in the gaps between the wiring patterns is heated and partially cured (B-staging). Then, in a resin polishing step, surfaces of the wiring patterns are polished using, for example, a ceramic buffer, thus removing resin from the surfaces of the wiring patterns. In a full curing step, the embedding resin that has filled in the gaps between the wiring patterns 18 and been partially cured is heated and fully cured (C-staging). As a result, the resin portion 20 formed of the embedding resin is formed. A heating temperature of the embedding resin in this full curing step is set, for example, in a range from 150° C to 180° C.

In a plating step after the full curing step, metal plating (not shown in the drawings) is applied to the surfaces of the wiring patterns 18, without the surfaces being polished. Thus, the circuit board 10 is completed. For example, a plating solution of copper, nickel or the like is employed for this metal plating. The thickness of the metal plating is set, for example, in a range from 0.1 $\mu$m to 0.4 $\mu$m. Oxidation of the surfaces of the wiring patterns 18 may be prevented by this metal plating. The completed circuit board 10 is then subjected to final scanning in a final scanning step.

Electronic components (not shown in the drawings) are mounted at the completed circuit board 10. A temperature during mounting (the reflow temperature) is set, for example, in a range from 260 °C to 300 °C. The electronic components may include, for example, semiconductor integrated circuits, transistors, diodes, light-emitting diodes, thyristors, capacitors, resistors, resistance arrays, coils, switches and so forth. These electronic components are bonded to the surfaces of the wiring patterns 18 using a conductive bonding material (not shown in the drawings) such as solder or the like. The electronic components and the circuit board 10 are sealed in by a sealing resin. Thus, an electronic module that is provided with the circuit board 10, the electronic components and the sealing resin is completed. The sealing resin is molded by, for example, a transfer mold.

[EXAMPLES]

Below, Examples are used to describe details of the present disclosure. However, the present disclosure is not to be limited by details recited in the Examples below.

Materials used in the Examples and Comparative Examples are as follows.

- The insulating layer 14: An insulating layer constituted of a filler and a resin, with a glass transition temperature (Tg), Young's modulus and coefficient of linear expansion shown in Table 4

- Epoxy resin: A varnish in which 73.5 parts by weight of a bisphenol-A type epoxy (EXA-850 CRP, manufactured by DIC Corporation) and 26.5 parts by weight of 4,4-diaminodiphenyl sulfone (SEIKACURE-S, manufactured by Seika Corporation) were mixed together, a predetermined amount of a filler (alumina or silica) was mixed into the varnish, a slurry thereof (an embedding resin raw material) was coated onto gaps between circuit coppers serving as wiring patterns, was dried (at 100°C for 30 minutes), and was then cured at 180°C
- Alumina: AS40, manufactured by Showa Denko K.K.
- Silica: FB-9454, manufactured by Denka Company Limited
- Base copper: C1020 1/2H, manufactured by Mitsubishi Materials Corporation

Four-layer beam stack bodies as described below were formed to serve as Examples 1 to 7 and Comparative Examples 1 and 2.

- Layer 1: The resin portion 20 formed of an embedding resin shown in Table 4
- Layer 2: The insulating layer 14
- Layer 3: A base copper serving as the metal base 12 (half thickness)
- Layer 4: A base copper serving as the metal base 12 (half thickness)

As shown in table 4, Comparative Example 1 used just the epoxy resin (with no filler) as the embedding resin.

Example 1 used the epoxy resin with 10% by volume of alumina as the embedding resin.
Example 2 used the epoxy resin with 20% by volume of alumina as the embedding resin.
Comparative Example 2 used the epoxy resin with 30% by volume of alumina as the embedding resin.
Example 3 used the epoxy resin with 40% by volume of alumina as the embedding resin.
Example 4 used the epoxy resin with 10% by volume of silica as the embedding resin.
Example 5 used the epoxy resin with 20% by volume of silica as the embedding resin.
Example 6 used the epoxy resin with 30% by volume of silica as the embedding resin.
Example 7 used the epoxy resin with 40% by volume of silica as the embedding resin.

The glass transition temperature (Tg) and Young's modulus of the resin portion 20 of each layer 1 and the insulating layer 14 of each layer 2 were measured by dynamic mechanical analysis (DMA) and the coefficients of linear expansion were measured by thermal mechanical analysis (TMA).
Measurement conditions for the DMA were as follows.

[Table 1]

| DMA | Condition |
|---|---|
| Sample size | Width 2 mm × length 50 mm × thickness 0.8 mm |
| Clamp spacing | 20 mm |
| Equipment | DYNAMIC VISCOELASTICITY MEASUREMENT DEVICE RSA-G2 (manufactured by TA Instruments) |
| Measurement mode | Tension |
| Temperature ramp rate | 2 °C/minute |
| Frequency | 1 Hz |
| Atmosphere | N2 |
| Temperature range | Room temperature to 300 °C |

Measurement conditions for the TMA were as follows.

[Table 2]

| TMA | Condition |
|---|---|
| Sample size | Width 5 mm × thickness 1.8 mm-2.7 mm |
| Equipment | THERMOMECHANICAL ANALYZER TMA8311 (manufactured by Rigaku Corporation) |
| Measurement mode | Compression |

(continued)

| TMA | Condition |
|---|---|
| Temperature ramp rate | 2 °C/minute |
| Measurement weight | 5 g |
| Atmosphere | N2 |
| Temperature range | -50 °C to 300 °C |

Stresses at the interface of the insulating layer 14 of layer 2 in contact with the resin portion 20 of layer 1 formed of the embedding resin were calculated for Examples 1 to 7 and Comparative Examples 1 and 2 shown in Table 4. "STACK BODY SIMPLE THERMAL WARPING CALCULATION TOOL ver. 1.7" manufactured by Wave Technology Inc. was used for the calculations. In order to find stresses from room temperature (25°C) to the reflow temperature for mounting (300°C) with a transition at the glass transition temperature (Tg) of the insulating layer 14 of 200°C, the stresses were calculated for two sets of temperature conditions: $T_0$ at room temperature (25°C) and $T_1$ at Tg (200°C); and $T_0$ at Tg (200°C) and $T_1$ at the reflow temperature (300°C).

Calculation conditions from room temperature to the glass transition temperature for Comparative Example 1 were as follows.

[Table 3]

| | Start ($T_0$) | End ($T_1$) |
|---|---|---|
| Temperature conditions (°C) | 25 | 200 |

| Layer No. | Modulus of elasticity E (MPa) | Coefficient of linear expansion (ppm/°C) | | Tg (°C) | Beam size (mm) | | |
|---|---|---|---|---|---|---|---|
| | | $\alpha 1$ (<Tg) | $\alpha 2$ (>Tg) | | Beam length L | Depth measurement b | Layer thickness h |
| Layer1 | 3080 | 54 | 166 | 200 | | | 0.5 |
| Layer2 | 16031 | 14 | 37 | 200 | 20 | 0.8 | 0.12 |
| Layer3 | 112000 | 17 | 17 | 300 | | | 0.75 |
| Layer4 | 112000 | 17 | 17 | 300 | | | 0.75 |

Fig. 7 shows the 4-layer beam stack structure in correspondence with stress inclinations at the respective layers of Comparative Example 1. For the stress values in Fig. 7, "+" indicates a tensile stress and "-" indicates a compressive stress. The stress at the interface of layer 2 in contact with layer 1 was 13.3 MPa.

The beam size of layer 1 shown in Table 3 and the respective values of layers 2 to 4 are the same in Examples 1 to 7 and Comparative Examples 1 and 2. Accordingly, similar calculations may be carried out for Comparative Example 2 and Examples 1 to 7. Stresses at the interface of the insulating layer 14 of layer 2 in contact with the resin portion 20 of layer 1 in Examples 1 to 7 and Comparative Examples 1 and 2 are shown in Table 4.

[Table 4]

| | Unit | Measurement method | Insulating layer 14 | Comparative Example 1 | Example 1 | Example 2 | Comparative Example 2 | Example 3 | Example 4 | Example 5 | Example 6 | Example 7 |
|---|---|---|---|---|---|---|---|---|---|---|---|---|
| | | | | Embedding resin without filler | Embedding resin with 10% by vol. alumina | Embedding resin with 20% by vol. alumina | Embedding resin with 30% by vol. alumina | Embedding resin with 40% by vol. alumina | Embedding resin with 10% by vol. silica | Embedding resin with 20% by vol. silica | Embedding resin with 30% by vol. silica | Embedding resin with 40% by vol. silica |
| Resin curing temperature | °C | - | - | 180 | 180 | 180 | 180 | 180 | 180 | 180 | 180 | 180 |
| Tg | °C | DMA | 200 | 200 | 200 | 200 | 200 | 200 | 200 | 200 | 200 | 200 |
| Young's modulus <Tg | MPa | DMA | 16031 | 3080 | 3240 | 4420 | 5970 | 9370 | 3110 | 3520 | 3770 | 4180 |
| Young's modulus >Tg | MPa | DMA | 3573 | 40 | 58 | 92 | 144 | 270 | 67 | 70 | 76 | 150 |
| Coefficient of linear expansion <Tg | ppm/°C | TMA | 14 | 54 | 45 | 40 | 37 | 27 | 49 | 45 | 42 | 32 |
| Coefficient of linear expansion >Tg | ppm/°C | TMA | 37 | 166 | 155 | 143 | 129 | 89 | 15.6 | 155 | 151 | 129 |
| Crack detection results | | | OK | NG | OK | OK | NG | OK | OK | OK | OK | OK |
| Insulating layer stress 25 to 200 °C | Mpa | | - | 13.3 | 12.2 | 12.6 | 13.2 | 11.9 | 12.6 | 12.5 | 12.3 | 10.8 |
| Insulating layer stress 200 °C to 300 °C | Mpa | | | -7.0 | -7.0 | -7.0 | -7.0 | -6.9 | -7.0 | -7.0 | -7.0 | -7.0 |

[Evaluation]

The stack bodies of Examples 1 to 7 and Comparative Examples 1 and 2 were evaluated for whether cracks formed in layer 2, the insulating layer 14, at the heating temperature for reflow. As the temperature for reflow, the temperature was ramped from 25° C to 300° C, being held for 30 s periods. Stack bodies in which no cracks occurs occurred are marked "OK" and stack bodies with cracks are marked "NG". The crack detection results are shown in Table 4. In a state in which no embedding resin was stacked, cracks did not occur in the insulating layer 14 of layer 2 when similarly heated to the temperature for reflow. From the crack detection results shown in Table 4, it can be seen that cracks did not occur in insulating layers with calculated stresses of 12.6 MPa or less. Comparing Example 1, Example 2, Comparative Example 2 and Example 3, the Young's modulus increased with increasing content amounts of alumina. Meanwhile, the coefficient of linear expansion decreased with increasing content amounts of alumina. Thus, it is seen that the calculated stresses changed in accordance with a balance between the Young's modulus and the coefficient of linear expansion. Therefore, it can be seen from Table 4 that the influence of stress in an embedding resin may be reduced by adjusting the balance between the Young's modulus and coefficient of linear expansion of the embedding resin such that stress at the interface with the insulating layer 14 is 12.6 MPa or less. Moreover, circuit boards in which these embedding resins fill in the gaps between wiring patterns may prevent cracks forming in the insulating layer due to heating in a subsequent reflow process.

An exemplary embodiment has been illustrated to describe the present disclosure, but the present disclosure may be embodied with numerous modifications in a scope not departing from the gist of the disclosure. It will also be clear that the scope of the present disclosure is not to be limited to the exemplary embodiment described above.

The disclosures of Japanese Patent Application No. 2022-179127 filed November 8, 2022, are incorporated into the present specification by reference in their entirety.

All references, patent applications and technical specifications cited in the present specification are incorporated by reference into the present specification to the same extent as if the individual references, patent applications and technical specifications were specifically and individually recited as being incorporated by reference.

**Claims**

1. An embedding resin, wherein,

   the embedding resin is a resin to fill in a gap between wiring patterns of a circuit board, and
   the embedding resin features a coefficient of linear expansion and a Young's modulus such that, in a stack in which a base substrate, an insulating layer and a resin portion that is formed of the embedding resin are stacked in this order, stress at an interface of the insulating layer that is in contact with the resin portion is at most 13.0 MPa, the stress being calculated by the following formula (C1) based on a 4-layer model using a temperature difference between room temperature and a glass transition temperature of the insulating resin:
   [Formula 1]

$$\sigma = \frac{P}{bh} + \frac{Ey}{R} \tag{C1}$$

   in which $\sigma$ represents stress (MPa), P represents axial force (N), b represents a depth measurement of the insulating layer (mm), h represents a thickness of the insulating layer (mm), E represents the Young's modulus (MPa), y represents distance from a neutral plane (mm), and R represents a radius of curvature (mm).

2. The embedding resin according to claim 1, wherein the embedding resin comprises a filler.

3. The embedding resin according to claim 1 or claim 2, wherein the embedding resin comprises an epoxy resin.

4. A circuit board comprising:

   a base substrate;
   an insulating layer stacked on the base substrate;
   a conductor layer stacked on the insulating layer at an opposite side from a side at which the base substrate is disposed, the conductor layer structuring wiring patterns; and
   a resin portion formed from the embedding resin according to claim 1 or claim 2, the resin portion filling in a gap between the wiring patterns.

5. An electronic module comprising:

   the circuit board according to claim 4;

an electronic component mounted at the circuit board; and
a sealing resin that seals in the circuit board and the electronic component.

6. A method for manufacturing a circuit board, comprising:

a preparing step of preparing a stack body in which a conductor layer structuring wiring patterns and a base substrate are stacked with an insulating layer therebetween; and
a resin filling step of filling in a gap between the wiring patterns with a raw material of the embedding resin according to claim 1 or claim 2.

# FIG.1

FIG.2

# FIG.3

NEUTRAL PLANE

# FIG.4

# FIG.5

# FIG.6

```
ETCHING STEP
        ↓
AUTOMATIC OPTICAL SCANNING STEP
        ↓
RESIN FILLING STEP
        ↓
PARTIAL CURING STEP
        ↓
RESIN POLISHING STEP
        ↓
FULL CURING STEP
        ↓
PLATING STEP
        ↓
FINAL SCANNING STEP
```

# FIG.7

| | LAYER NO. | STRESS (MPa) |
|---|---|---|
| STRESSES OF LAYERS IN 4-LAYER BEAM | Layer1 | -18.56 |
| | | -19.01 |
| | Layer2 | 13.26 |
| | | 12.69 |
| | Layer3 | 29.89 |
| | | 5.22 |
| | Layer4 | 5.22 |
| | | -19.44 |

Layer1

Layer 1–layer 2 INTERFACE

Layer2

Layer 2–layer 3 INTERFACE

Layer3

Layer 3–layer 4 INTERFACE

Layer4

## INTERNATIONAL SEARCH REPORT

| International application No. |
| --- |
| **PCT/JP2023/039917** |

| A. | CLASSIFICATION OF SUBJECT MATTER |
| --- | --- |

*H05K 3/28*(2006.01)i; *H01L 23/12*(2006.01)i; *H05K 1/05*(2006.01)i
FI:   H05K3/28 C; H01L23/12 Z; H05K1/05 A

According to International Patent Classification (IPC) or to both national classification and IPC

| B. | FIELDS SEARCHED |
| --- | --- |

Minimum documentation searched (classification system followed by classification symbols)

H05K3/28; H01L23/12; H05K1/05

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2007-318096 A (SANYO ELECTRIC CO., LTD.) 06 December 2007 (2007-12-06) paragraphs [0015]-[0032], [0070], fig. 1 | 1-6 |
| Y | JP 2019-125730 A (MITSUBISHI ELECTRIC CORP.) 25 July 2019 (2019-07-25) paragraphs [0011]-[0012], [0032]-[0035], fig. 2 | 1-6 |
| A | JP 2007-173870 A (TOSHIBA CORP.) 05 July 2007 (2007-07-05) | 1-6 |

☐ Further documents are listed in the continuation of Box C.   ☑ See patent family annex.

| | | | |
| --- | --- | --- | --- |
| * | Special categories of cited documents: | "T" | later document published after the international filing date or priority date and not in conflict with the application but cited to understand the principle or theory underlying the invention |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **27 December 2023** | **16 January 2024** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

<div align="center">

**INTERNATIONAL SEARCH REPORT**
Information on patent family members

</div>

| International application No. |
| --- |
| **PCT/JP2023/039917** |

| Patent document cited in search report | | | Publication date (day/month/year) | Patent family member(s) | Publication date (day/month/year) |
| --- | --- | --- | --- | --- | --- |
| JP | 2007-318096 | A | 06 December 2007 | US 2007/0252270 A1 paragraphs [0031]-[0048], [0088], fig. 1 CN 101064993 A | |
| JP | 2019-125730 | A | 25 July 2019 | (Family: none) | |
| JP | 2007-173870 | A | 05 July 2007 | US 2001/0020736 A1 US 6448665 B1 KR 10-1999-0037125 A | |

Form PCT/ISA/210 (patent family annex) (January 2015)

REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2021034534 A

- JP 2022179127 A

**Non-patent literature cited in the description**

- **J. ODA** ; **S. ABE**. Analysis of Stress and Deflection of Printed Plate Board Using Multilayered Beam Theory. *Transactions of the Japan Society of Mechanical Engineers. A*, 1993, vol. 59 (563), 1777-1782